Europäisches Patentamt

European Patent Office

Office européen des brevets

(19)

(11) **EP 1 203 971 A1**

(12) **EUROPEAN PATENT APPLICATION**

(43) Date of publication:
**08.05.2002 Bulletin 2002/19**

(51) Int Cl.[7]: **G02B 6/42**, H01S 3/30

(21) Application number: **01124358.1**

(22) Date of filing: **23.10.2001**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **26.10.2000 JP 2000326671**

(71) Applicant: **THE FURUKAWA ELECTRIC CO., LTD.**
**Tokyo (JP)**

(72) Inventor: **Koyanagi, Satoshi,**
**The Furukawa Electric Co., Ltd.**
**Tokyo (JP)**

(74) Representative: **Modiano, Guido, Dr.-Ing. et al**
**Modiano, Josif, Pisanty & Staub,**
**Baaderstrasse 3**
**80469 München (DE)**

(54) **Depolarised semiconductor laser module, manufacturing method thereof and Raman amplifier**

(57) A semiconductor laser module (1) comprising a semiconductor laser device (6), a pigtail fiber (5), and optical lens (2c) disposed to optically couple the semiconductor laser device to said pigtail fiber, a method of manufacturing the semiconductor laser module, and a Raman amplifier. The pigtail fiber (5) is a polarization maintaining optical fiber with a polarization maintaining axis shifted by a predetermined angle with respect to a polarization direction of a laser beam emitted from the semiconductor laser device.

# FIG. 1A

EP 1 203 971 A1

# EP 1 203 971 A1

**Description**

## BACKGROUND OF THE INVENTION

Field of the invention

The present invention relates to a semiconductor laser module, a method of manufacturing the semiconductor laser module and a Raman amplifier using the semiconductor laser module.

Description of the Related Arts

With the advance of dense wavelength division multiplexing (DWDM) optical communication, an expectation on a Raman amplifier used as means of amplifying light having a broader band than erbium-doped fiber amplifier (EDFA) has been increased. In the Raman amplification, light is amplified in a state where the polarization direction of signal light agrees with the polarization direction of exciting light (pump light). Thus, in the Raman amplification, it is necessary to significantly minimize the influence of the deviations between the polarization planes of signal light and exciting light. Thus, for example, by depolarizing the polarization of exciting light, degree of polarization has been decreased.

On the other hand, in a conventional semiconductor laser module having a Polarization Maintaining Fiber (hereinafter referred to as "PMF"), from a viewpoint of polarization combination, it is necessary to match the polarization direction of a laser beam emitted from a semiconductor laser and incident into the PMF with a polarization maintaining axis of the PMF. Accordingly, in a conventional semiconductor laser module, while monitoring the laser beam emitted from the PMF, an angle around the optical axis is adjusted so that an extinction ratio becomes a maximum, whereby the semiconductor laser and the PMF are optically coupled with each other.

Here, when the light intensities in X and Y axial directions of laser beam emitted from a core Cr are Px and Py, respectively, in the PMF F shown in Fig. 5, the extinction ratio R (dB) has a value defined by the following equation. In this case, the PMF F has two stress imparting portions Pst in clad C1 as shown in Fig. 5.

$$R=10 \log_{10}|Px/Py|$$

When the above-mentioned semiconductor laser module is used as an exciting light source of the Raman amplifier, a laser beam having a large extinction ratio (>10dB) is required to be depolarized to make a spectral width narrow band by fiber Bragg grating (hereinafter referred to as "FBG") and also to prevent the variation of the gain of the Raman amplifier by the dependence on relative relationship between the polarization state of exciting light and the polarization state of signal light.

The depolarizing methods include a method of polarization-combining two laser beams emitted from two semiconductor laser modules having the same oscillation wavelength by a polarization combining device, and a method of reducing the degree of polarization by mounting a PMF on one semiconductor laser module so that the polarization plane of a laser beam coincides with the polarization maintaining axis, and shifting the polarization maintaining axis by 45 degrees to fusion-splice another PMF (depolarizer) having a length of a few meter to a few tens meter whereby a pigtail fiber is formed.

The latter method has an advantage that the number of semiconductor laser module, which is used, can be decreased, but, since another PMF is further fusion-spliced to the pigtail fiber, the intensity of laser beam emitted from the PMF is reduced by the connection loss, which can be poorly output as the excitation light source for a Raman amplifier. In addition, when the mutual fibers are accurately positioned around the optical axis during fusion splicing and an angle between the mutual polarization maintaining axes is not brought near to 45 degrees sufficiently, the above-mentioned semiconductor laser module involves problems in that it cannot decrease the degree of polarization sufficiently by the fusion-spliced PMF or the length of PMF, required for obtaining a significantly small extinction ratio, is significantly increased. Further, the accurate positioning of the PMF around the central axis during fusion-splicing is significantly difficult.

## SUMMARY OF THE INVENTION

An object of the present invention is to provide a semiconductor laser module, which can restrict the degree of polarization to a small level sufficiently in a module state and is not required for the additional optical coupling of another PMF to be depolarized, a method of manufacturing the semiconductor laser module and a Raman amplifier using the semiconductor laser module.

To attain the above-mentioned object in the semiconductor laser module according to the present invention comprising a semiconductor laser device, a pigtail fiber, and optical lens disposed to optically couple the semiconductor laser device to the pigtail fiber, wherein the pigtail fiber is a polarization maintaining optical fiber with a polarization maintaining axis shifted by a predetermined angle with respect to a polarization direction of a laser beam emitted from the semiconductor laser device.

Preferably, the semiconductor laser module further comprising a package configured to house the semiconductor laser device and the optical lens, the package includes an emission portion which outputs light, a fiber fixing member fixed to an end portion of the pigtail fiber, and wherein the emission portion of the package and the fiber fixing member are abutted and fixed to each other.

An extinction ratio of the laser beam emitted from the pigtail fiber is preferably 4 dB or less.

The predetermined between the polarization direction of the laser beam and the polarization maintaining axis of the pigtail fiber is preferably 45 degrees $\pm$ no more than 12 degrees.

Preferably, the semiconductor laser module includes an optical feedback portion configured to feedback the laser beam emitted from the semiconductor laser device.

Preferably, the pigtail fiber forms a fiber Bragg grating configured to secure an oscillation wavelength of the laser beam emitted from the semiconductor laser device.

Further, the pigtail fiber is preferably set to have a length of 10 m or less.

The pigtail fiber is more preferably set to have a length of 5 m or less.

Preferably, the semiconductor laser module is directed to serve as an excitation light source for a Raman amplifier.

Further, to attain the above-mentioned object in a method of manufacturing the semiconductor laser module having a semiconductor laser device, a pigtail fiber which is a polarization maintaining optical fiber, and an optical coupler configured to couple a laser beam emitted from the semiconductor laser device to the pigtail fiber, the method comprising steps of orienting a polarization maintaining axis of the pigtail fiber to be shifted by a predetermined angle from a polarization direction of the laser beam emitted from the semiconductor laser device, and optically connecting the pigtail fiber to the optical coupler with the polarization maintaining axis of the pigtail fiber shifted by the predetermined angle from the polarization direction of the laser beam emitted from the semiconductor laser device.

Preferably, the method further comprising a step of adjusting the polarization maintaining axis of the pigtail fiber to minimize an extinction ratio of the laser beam emitted from the pigtail fiber which is optically connected to the optical coupler.

The extinction ratio of the laser emitted from the pigtail fiber is preferably set at 4 dB or less.

Further, preferably, the step of orienting a polarization maintaining axis of the pigtail fiber further comprises shifting the pigtail fiber from an angle about the optical axis where an extinction ratio of the laser beam emitted from the pigtail fiber becomes a maximum by the predetermined angle, the predetermined angle being 45 degrees $\pm$ no more than 12 degrees.

Further, to attain the above-mentioned object in the semiconductor laser module according to the present invention comprising a semiconductor laser device configured to emit a laser beam, a pigtail fiber; and optical coupling means for connecting the laser beam emitted from the semiconductor laser device to the pigtail fiber; wherein the pigtail fiber is a polarization maintaining optical fiber with a polarization maintaining axis shifted by a predetermined angle with respect to a polarization direction of the laser beam.

Further, to attain the above-mentioned object in the Raman amplifier according to the present invention comprising an amplification medium, and a semiconductor laser module as an excitation light source for the amplification medium, the semiconductor laser module including a pigtail fiber, and an optical lens disposed to optically couple the semiconductor laser module to the pigtail fiber, wherein the pigtail fiber is a polarization maintaining optical fiber with a polarization maintaining axis shifted by a predetermined angle with respect to a polarization direction of a laser beam emitted from the semiconductor laser module.

According to the present invention, a semiconductor laser module, which can restrict the degree of polarization to a small level sufficiently in a module state and is not required for the additional optical coupling of another PMF to be depolarized, a method of manufacturing the semiconductor laser module and a Raman amplifier using the semiconductor laser module, can be provided.

Therefore, one semiconductor laser module permits exciting light having a sufficiently small degree of polarization, and polarization dependent gain (PDG) can be decreased to a significantly low level, when used in the Raman amplifier.

The above and other objects, features and advantages of the present invention will become further apparent from the following detailed descriptions with reference to the accompanying drawings.

**BRIEF DESCRIPTION OF THE DRAWINGS**

Fig. 1A is an exploded perspective view showing a configuration of a semiconductor laser module of the present invention;

Fig. 1B is a front cross-sectional view of the semiconductor laser module of Fig. 1A;

Fig. 2 is a model view showing a method of manufacturing the semiconductor laser module of Figs. 1A and 1B, and explaining the relationship between the method and an angle formed between the polarization maintaining axis of a PMF and the polarization direction of laser beam emitted from a semiconductor laser device;

Fig. 3 is a characteristic graph of the polarization degree showing one example of measurements of fiber lengths and polarization degrees measured from the laser beam emitted from the semiconductor laser device and the emitted light after the laser beam was transmitted through the PMF;

Fig. 4 is a schematic block diagram of a Raman amplifier of the present invention using the semiconductor laser module of Figs. 1A and 1B; and

Fig. 5 is an end face view of a PANDA fiber as one example of the PMF.

**DETAILED DESCRIPTION OF THE PREFERRED EMBODIMENTS**

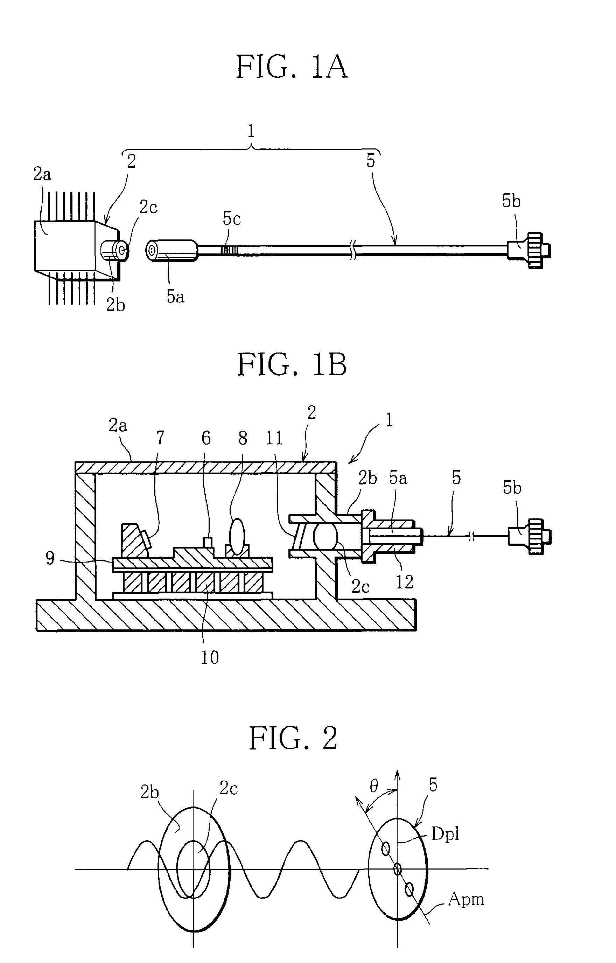

A semiconductor laser module of the present invention, a method of manufacturing the semiconductor laser module and one embodiment according to a Raman amplifier using the semiconductor laser module will be described below in detail with reference to Figs. 1 to 4.

A semiconductor laser module 1 includes a semiconductor laser unit 2 and a PMF 5, as shown in Figs. 1A and 1B.

The semiconductor laser unit 2 includes a semiconductor laser device 6, which emits forward output light (laser beam) in the wavelength range of 1200 to 1550 nm used in optical communication into a package 2a molded of metallic material, a photodiode 7, which monitors the backward output light from the semiconductor laser device 6, a collimator lens 8, which makes a laser beam from the semiconductor laser device 6 into parallel light, a base 9, which mounts the above-mentioned devices 6 to 8, and a thermomodule (Peltier element) 10 which mounts the base 9, and the like. In the package 2a a hermetic glass 11 and a condenser lens 2c are fixed to a cylindrical emission portion 2b. The collimator lens 8 and the condenser lens 2c serve as optical coupling means, which couples the laser beam emitted from the semiconductor laser device 6 with the PMF 5.

The PMF 5 is a pigtail fiber of the semiconductor laser module 1, in which a metallic sleeve 5a is attached to one end and an optical connector 5b is attached to the other end thereof. The PMF 5 includes a so-called PANDA (polarization-maintaining and absorption-reducing) fiber, formed a stress-imparting portion having a circular cross-section on both sides of the core, or a bow-tie fiber, forming a stress-imparting portion having a fan-shaped cross-section on both sides of the core. The PMF 5 has a FBG 5c, which secures the oscillation wavelength of the semiconductor laser device 6 in the core (not shown), and the length of the PMF 5 is at least 1 m. The polarization-maintaining axis of the PMF 5 is adjusted in a state where it is shifted from the polarization direction of the laser beam emitted from the semiconductor laser device 6, by about 45 degrees. In this state, the sleeve 5a is fixed by welding to the emission portion 2b through an adjusting member 12 with YAG laser or the like. Thus, the laser beam emitted from the semiconductor laser device 6 enter into the PMF 5 through the collimator lens 8 and the condenser lens 2c. The adjusting member 12 is previously fixed by welding to the emission portion 2b.

The adjustment of the above-mentioned polarization maintaining axis is carried out by rotating the PMF 5 while monitoring the extinction ratio of laser beam emitted from the optical connector 5b side using an extinction ratio monitoring device, and fixing the sleeve 5a to the adjusting member 12 at the position where a value of the extinction ratio is minimized. Then, it is preferable that the value of the extinction ratio is as small as possible, that is near 0 dB. However, if the measured value in the extinction ratio monitoring device is 4 dB or less, the PDG level can be set to a no-problem level that is 0.1 dB or less when used a Raman amplifier. Further, if the extinction ratio is set to 3 dB or less, more preferably to 2 dB or less, The PDG can be further decreased (0.05 dB).

As explained above, when an angular adjustment is carried out so that the extinction ratio of laser beam is emitted from the PMF 5 is minimized using an extinction ratio monitoring device, the measuring accuracy of the extinction ratio is possibly low near 0 dB that is the adjustment target value and the rate of change in extinction ratio with respect to the angular change is possibly small. Thus, the tact time required for the angular adjustment is increased and some extinction ratios cannot be accurately adjusted to a minimum value.

Therefore, after the angle, at which the extinction ratio becomes a maximum, is determined while monitoring the extinction ratio of laser beam emitted from the PMF 5 with the extinction ratio monitoring device, the PMF 5 may be rotated by 45 degrees $\pm$ 12 degrees or less, more preferably, 45 degrees $\pm$ 6 degrees or less to secure the sleeve 5a to the adjusting member 12. This angle corresponds with the angle θ between the polarization maintaining axis Apm and the polarization direction Dp1 of laser beam emitted from the semiconductor laser device 6, as shown in Fig. 2. In this case, in a close point where the extinction ratio becomes a maximum value, the measurement accuracy of the extinction ratio is high, and the rate of change in the extinction ratio with the angular change is large. Accordingly, the tact time required for the angular adjustment can be preferably reduced. Further, in setting of a range of 45 degrees ± 6 or less, it is particularly preferable that 15% or less of an extinction ratio and 0.5 dB or less of PDG in the Raman amplifier can be realized.

Since the semiconductor laser module 1 is formed as explained above, the laser beam emitted from the semiconductor laser device 6 is focused by the collimator lens 8 and the condenser lens 2c within the package 2a, and emitted to the PMF 5. Then, the laser beam entered into the PMF 5 is depolarized according to the length of the PMF 5 while being transmitted to the optical connector 5b side, and is emitted from the optical connector 5b.

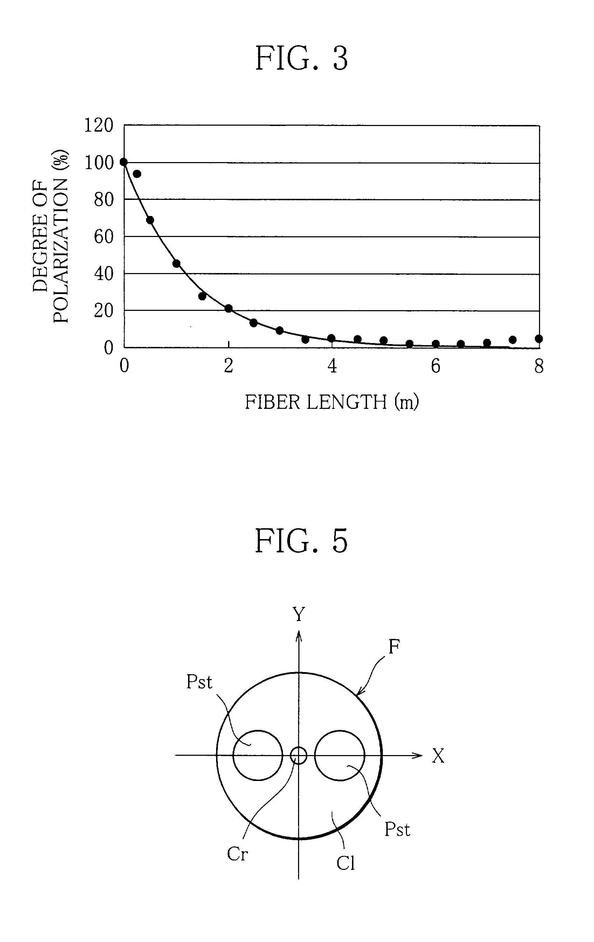

For example, in a case where the PANDA fiber is used as the PMF 5 in the semiconductor laser module 1, when the relationships between the length (m) of the fiber and the degree of polarization (%) were actually measured, results shown by black points in Fig. 3 were obtained. It is noted that in Fig. 3, the solid line represents a theoretically computed values based on an approximate equation expressing the relationships between the respective mode delay time and the degree of interference between the high speed axis and low speed axis of the PMF 5 in a case where the spectral shape of the optical source was a Lorentz type. It could be found from Fig. 3 that if the PMF 5 had a length of at least 1.5 m, DOP (Degree of polarization) of laser beam emitted from the semiconductor laser device 6 could be approximately 30%.

Here, the degree of polarizarion is defined as follows.

DOP = (strength of polarization component)/{(strength of non-polarization component) + (strength of polarization component)} x 100

As described above, by using a semiconductor laser module having a degree of polarization of 30% or less as an exciting optical source in the Raman amplifier, PDG can be set to 0.1 dB or less. Further, preferably, when the length of the PMF 5 is 2 m or longer, the degree of polarization is decreased to 15%, whereby the PDG of the Raman amplifier can be set to 0.05 dB or less.

Further, in the semiconductor laser module 1, the entire pigtail fiber consisting of the PMF 5 has a polarization maintaining axis shifted by about 45 degrees from the polarization direction of laser beam emitted from the semiconductor laser device 6, whereby the mutual fibers are not fusion-spliced to each other as in a prior art. Thus, in the semiconductor laser module 1 the length of laser beam emitted from the PMF is not decreased by the connection loss, and a sufficient output can be ensured as an excitation light source for Raman amplifier.

Here, with the semiconductor laser module 1 provided with a FBG 5c, which serves as an optical feedback portion, in the PMF 5, and a semiconductor laser module having the same structure as the semiconductor laser module 1 except that the PMF 5 is not provided with FBG 5c, DOPs were measured by experiments. The results are shown in Table 1.

## Table 1

| Drive-Current | | Result of DOP measurement | | | | | | | | |
|---|---|---|---|---|---|---|---|---|---|---|
| | | Result of DOP measurement in embodiment | | | | | | | Prior Art | |
| | | No FBG | | | | FBG | | | No FBG | |
| Depolarizer length | | 1.5m | | 5m | | 1.5m | | 5m | | 5m |
| | | min | max | min | max | min | max | min | max | min | max |
| | 100mA | 36.2 | 38.1 | 20.0 | 28.7 | 82.9 | 84.8 | 17.5 | 23.3 | 35.8 | 36.4 |
| | 300mA | 22.5 | 25.1 | 13.3 | 14.0 | 57.6 | 58.0 | 14.0 | 15.3 | 22.4 | 22.8 |
| | 500mA | 19.3 | 23.8 | 9.6 | 13.1 | 40.7 | 41.8 | 11.9 | 12.7 | 22.7 | 23.8 |
| | 700mA | 15.5 | 21.5 | 10.4 | 11.0 | 33.1 | 34.0 | 14.1 | 14.8 | 20.7 | 21.5 |
| | 900ma | 3.2 | 10.7 | 9.3 | 10.9 | 28.2 | 29.0 | 13.7 | 14.4 | 19.7 | 20.0 |
| | 1100mA | - | - | - | - | 23.7 | 25.0 | 13.9 | 14.2 | - | - |
| | 1300mA | - | - | - | - | 22.2 | 22.9 | 13.3 | 14.4 | - | - |

As shown in Table 1, in the semiconductor laser module having no FBG, even if the length of the PMF 5 used as a depolarizer is 1.5 m, 15% or less of DOP can be realized in a driving current 900 mA. If a PMF 5 having a length of 5 m is used, it can be found that DOP in a lower driving current region is further improved.

On the other hand, in a case where the semiconductor laser module provided with FBG 5c in the PMF 5, the reduction of DOP is not sufficient in the length; 1.5 m of the PMF 5 used as a depolarizer. However, in the PMF 5 having a length of 5 m, DOP is 15% or less in a region of a driving current 300 mA or more. Further, by setting the length of the PMF 5 at, for example, about 10 m, it is conceived that 10% or less of DOP can be sufficiently realized.

It should be noted that DOP was 20% in a depolarizer of 5 m in the semiconductor laser module explained in a prior art and the reduction of DOP was insufficient.

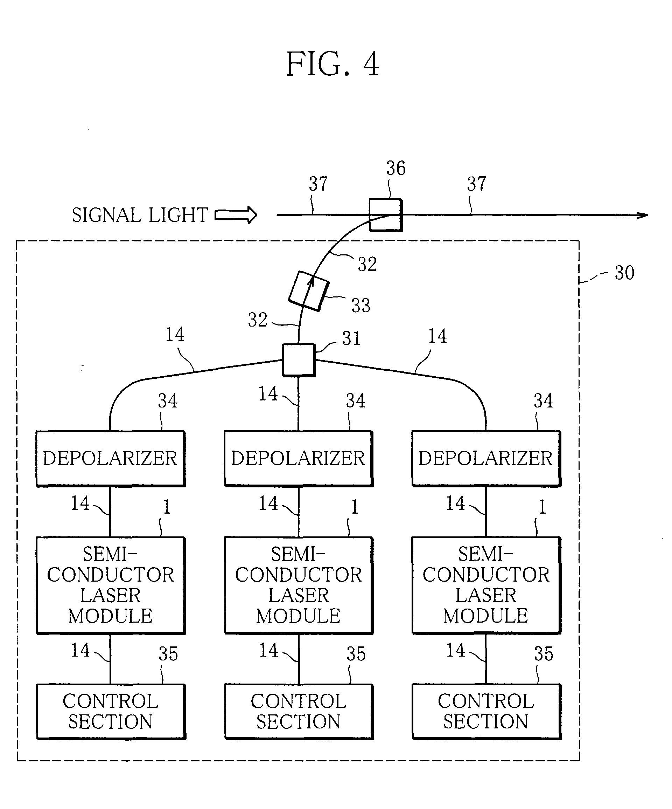

The semiconductor laser module 1 having the above-described properties can be used as an excitation light source of the Raman amplifier. One embodiment thereof is shown in Fig. 4.

The Raman amplifier 30 is a forward excitation type optical amplifier, which includes a plurality of semiconductor laser modules 1, optical fibers 14, which transmit laser beams emitted from the respective semiconductor laser modules 1, a wavelength division multiplexing (WDM) coupler 31, which combines these laser beams, an optical fiber 32, which transmits these combined beams, a polarization non-depending type optical isolator 33 disposed in the optical fiber 32, depolarizers 34 each consisting of a PMF disposed in the middle of the optical fiber 14, and control sections 35.

The plurality of semiconductor laser modules 1 transmit laser beams having different wavelengths from each other based on the operation control of the semiconductor laser device 6 by the control section 35, for example, a control of the supplied current or the temperature of the thermomodule 10.

The optical isolator 33 passes the laser beam emitted from the semiconductor laser module 1, and cuts light, which return to the semiconductor laser modules 1.

The depolarizer 34 reduces the degree of polarization of laser beam emitted from the semiconductor laser module 1 to be depolarized.

In such a Raman amplifier 30, the laser beam emitted from each semiconductor laser module 1 is depolarized with the depolarizer 34, the beams having different wavelengths are combined with each other with WDM coupler 31. Then, after the combined beams are passed through the optical isolator 33, they enter the optical fiber 37, which transmits signal light, from the optical fiber 32 through the WDM coupler 36.

The signal light within the optical fiber 37 receives in this manner the Raman effect by the incident laser beam (exciting light) and is transmitted while being amplified.

Thus, the Raman amplifier 30 according to the embodiment of the present invention uses the semiconductor laser module 1, and needs no optical connection with additional PMF for depolarization.

It is noted that the above-mentioned Raman amplifier 30 was described as a forward excitation type, but a backward excitation type- or a two-way excitation type Raman amplifier may be, of course, used.

Further, the optical feedback portion used in the semiconductor laser module of the present invention is not limited to FBG, but for example a diffraction grating formed in the vicinity of an active layer in the semiconductor laser device may be used.

Where technical features mentioned in any claim are followed by reference signs, those reference signs have been included for the sole purpose of increasing the intelligibility of the claims and accordingly, such reference signs do not have any limiting effect on the scope of each element identified by way of example by such reference signs.

**Claims**

1.   A semiconductor laser module comprising:

   a semiconductor laser device;
   a pigtail fiber; and
   an optical lens disposed to optically couple said semiconductor laser device to said pigtail fiber,

   wherein said pigtail fiber is a polarization maintaining optical fiber with a polarization maintaining axis shifted by a predetermined angle with respect to a polarization direction of a laser beam emitted from said semiconductor laser device.

2.   The semiconductor laser module according to claim 1, further comprising:

   a package configured to house said semiconductor laser device and said optical lens, said package includes an emission portion which outputs light,
   a fiber fixing member fixed to an end portion of said pigtail fiber, and

   wherein said emission portion of said package and said fiber fixing member are abutted and fixed to each other.

3.   The semiconductor laser module according to claim 1,
   wherein an extinction ratio of the laser beam emitted from said pigtail fiber is 4 dB or less.

4.   The semiconductor laser module according to any of claim 1 to 3,
   wherein the predetermined angle between the polarization direction of said laser beam and the polarization maintaining axis of said pigtail fiber is 45 degrees ± no more than 12 degrees.

5.   The semiconductor laser module according to any of claim 1 to 4, further comprising:

   an optical feedback portion configured to feedback the laser beam emitted from said semiconductor laser device.

6.   The semiconductor laser module according to any of claims 1 to 5,
   wherein said pigtail fiber is provided with a fiber Bragg grating configured to secure an oscillation wavelength of the laser beam emitted from said semiconductor laser device.

7.   The semiconductor laser module according to any of claims 1 to 6,
   wherein said pigtail fiber has a length of 10 m or less.

8.   The semiconductor laser module according to any of claims 1 to 7,
   wherein said pigtail fiber has a length of 5 m or less.

9.   The semiconductor laser module according to any of claims 1 to 8,
   wherein an optical output of said semiconductor laser module is directed to serve as an excitation light source for a Raman amplifier.

**10.** A method of manufacturing a semiconductor laser module having a semiconductor laser device, a pigtail fiber which is a polarization maintaining optical fiber, and an optical coupler configured to couple a laser beam emitted from said semiconductor laser device to said pigtail fiber, the method comprising steps of:

orienting a polarization maintaining axis of said pigtail fiber to be shifted by a predetermined angle from a polarization direction of the laser beam emitted from said semiconductor laser device; and
optically connecting said pigtail fiber to said optical coupler with the polarization maintaining axis of said pigtail fiber shifted by said predetermined angle from the polarization direction of the laser beam emitted from said semiconductor laser device.

**11.** The method of manufacturing a semiconductor laser module according to claim 10, further comprising a step of:

adjusting the polarization maintaining axis of said pigtail fiber to minimize an extinction ratio of the laser beam emitted from the pigtail fiber which is optically connected to said optical coupler.

**12.** The method of manufacturing a semiconductor laser module according to claim 10, wherein an extinction ratio of the laser beam emitted from said pigtail fiber is 4 dB or less.

**13.** The method of manufacturing a semiconductor laser module according to any of claims 10 to 12, said step of orienting a polarization maintaining axis of said pigtail fiber further comprising:

shifting said pigtail fiber from an angle about the optical axis where an extinction ratio of the laser beam emitted from said pigtail fiber becomes a maximum by the predetermined angle, said predetermined angle being 45 degrees ± no more than 12 degrees.

**14.** A semiconductor laser module comprising:

a semiconductor laser device configured to emit a laser beam;
a pigtail fiber; and
optical coupling means for connecting the laser beam emitted from said semiconductor laser device to said pigtail fiber;

wherein said pigtail fiber is a polarization maintaining optical fiber with a polarization maintaining axis shifted by a predetermined angle with respect to a polarization direction of said laser beam.

**15.** A Raman amplifier comprising:

an amplification medium; and
a semiconductor laser module as an excitation light source for said amplification medium, said semiconductor laser module including

a pigtail fiber, and
an optical lens disposed to optically couple said semiconductor laser module to said pigtail fiber,

wherein said pigtail fiber is a polarization maintaining optical fiber with a polarization maintaining axis shifted by a predetermined angle with respect to a polarization direction of a laser beam emitted from said semiconductor laser module.

# FIG. 1A

# FIG. 1B

# FIG. 2

# FIG. 3

# FIG. 5

# FIG. 4

SIGNAL LIGHT ⟹

37    36    37

30

32

33

32

31

14    14    14    14

| DEPOLARIZER | DEPOLARIZER | DEPOLARIZER |
|---|---|---|

34    34    34

14    1    14    1    14    1

| SEMI-CONDUCTOR LASER MODULE | SEMI-CONDUCTOR LASER MODULE | SEMI-CONDUCTOR LASER MODULE |
|---|---|---|

14    35    14    35    14    35

| CONTROL SECTION | CONTROL SECTION | CONTROL SECTION |
|---|---|---|

EP 1 203 971 A1

**European Patent Office**

## EUROPEAN SEARCH REPORT

Application Number

EP 01 12 4358

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EP 0 474 389 A (SUMITOMO ELECTRIC INDUSTRIES) 11 March 1992 (1992-03-11) * column 9, line 44 - column 10, line 21 * * column 11, line 23,24 * * column 11, line 47 * * column 14, line 45 - column 15, line 16; figure 5 * | 1-4,7-14 | G02B6/42 H01S3/30 |
| Y | | 1,5,6,15 | |
| Y | YOSHIHIRO EMORI ET AL: "Cost-effective depolarized diode pump unit designed for C-band flat-gain Raman amplifiers to control EDFA gain profile" OPTICAL FIBER COMMUNICATION CONFERENCE, TECHNICAL DIGEST POSTCONFERENCE EDITION, TRENDS IN OPTICS AND PHOTONICS, vol. 37, 7 - 10 March 2000, pages 106-108, XP002187327 Baltimore, MD, USA * the whole document * | 1,5,6,15 | |
| X,P | EP 1 081 813 A (FURUKAWA ELECTRIC CO LTD) 7 March 2001 (2001-03-07) * page 6, paragraph 30; figures 3A-3C * | 14 | TECHNICAL FIELDS SEARCHED (Int.Cl.7) G02B H01S |

The present search report has been drawn up for all claims

| Place of search | Date of completion of the search | Examiner |
|---|---|---|
| MUNICH | 15 January 2002 | Riblet, P |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

12

## ANNEX TO THE EUROPEAN SEARCH REPORT
## ON EUROPEAN PATENT APPLICATION NO.

EP 01 12 4358

This annex lists the patent family members relating to the patent documents cited in the above-mentioned European search report.
The members are as contained in the European Patent Office EDP file on
The European Patent Office is in no way liable for these particulars which are merely given for the purpose of information.

15-01-2002

| Patent document cited in search report | | Publication date | Patent family member(s) | | Publication date |
|---|---|---|---|---|---|
| EP 0474389 | A | 11-03-1992 | JP | 2751599 B2 | 18-05-1998 |
| | | | JP | 4106416 A | 08-04-1992 |
| | | | JP | 2591852 B2 | 19-03-1997 |
| | | | JP | 4106420 A | 08-04-1992 |
| | | | JP | 2571870 B2 | 16-01-1997 |
| | | | JP | 4106417 A | 08-04-1992 |
| | | | CA | 2049382 A1 | 28-02-1992 |
| | | | DE | 69107549 D1 | 30-03-1995 |
| | | | DE | 69107549 T2 | 22-06-1995 |
| | | | EP | 0474389 A1 | 11-03-1992 |
| | | | KR | 9607746 B1 | 11-06-1996 |
| | | | US | 5371595 A | 06-12-1994 |
| | | | US | 5245407 A | 14-09-1993 |
| EP 1081813 | A | 07-03-2001 | EP | 1081813 A2 | 07-03-2001 |
| | | | JP | 2001147454 A | 29-05-2001 |

EPO FORM P0459

For more details about this annex : see Official Journal of the European Patent Office, No. 12/82